# EUROPEAN PATENT SPECIFICATION

(11) **EP 3 712 734 B1**
(45) Date of publication and mention of the grant of the patent: **03.08.2022**
(21) Application number: 18875763.7
(22) Date of filing: 09.05.2018
(51) Int. Cl.: G05B 19/042, H03K 19/0175

(54) **SAFE-INPUT DYNAMIC SAMPLING CIRCUIT**
DYNAMISCHE ABTASTSCHALTUNG MIT SICHEREM EINGANG
CIRCUIT D'ÉCHANTILLONNAGE DYNAMIQUE À ENTRÉE SÛRE

(30) Priority: 13.11.2017 CN 201711116439
(43) Date of publication of application: 23.09.2020
(73) Proprietor: CRSC RESEARCH & DESIGN INSTITUTE GROUP CO., LTD., Fengtai District Beijing 100070 (CN)
(72) Inventor: ZHU, Lixiong, Beijing 100070 (CN); WANG, Hailong, Beijing 100070 (CN); NIU, Jianhua, Beijing 100070 (CN); ZHOU, Wei, Beijing 100070 (CN); HE, Longlong, Beijing 100070 (CN); HUANG, Binbin, Beijing 100070 (CN); ZHOU, Rong, Beijing 100070 (CN); MENG, Qingyao, Beijing 100070 (CN)
(74) Representative: Würmser, Julian
(86) International application number: PCT/CN2018/086116
(87) International publication number: WO 2019/091070

(56) References cited:
- CN-A- 101 414 187
- CN-A- 103 473 942
- CN-A- 106 941 387
- CN-A- 108 153 274
- CN-B- 104 505 842
- CN-U- 201 656 952
- CN-U- 202 632 100
- CN-U- 204 360 108
- CN-Y- 201 418 038

## Description

### CROSS-REFERENCE TO RELATED APPLICATIONS

This application claims priority from Chinese Patent Application No. 201711116439.0 filed on November 13, 2017.

### TECHNICAL FIELD

The present disclosure relates to the field of train control system, and more particularly to a vital digital input dynamic sampling circuit.

### BACKGROUND

There is a large amount of digital signals in the railway system, and the signal control system needs to acquire the digital signals to realize acquisition of external states. Due to failure of electronic devices and other reasons, signals will be fixed in a high or low logic state, and conditions of input signals cannot be truly reflected, which may cause the signal control system to obtain incorrect input information, thereby causing a logic error and further affecting traffic safety.

In the railway system, fixedly, the input signal being 1 is a wrong side and the input signal being 0 is a right side. Therefore, in order to ensure safety of the system, it is necessary to reduce the probability that signals at the wrong side are misjudged.
CN 104 505 842 B aims to disclose a zero-crossing triggering circuit based on a bidirectional silicon-controlled switch, including an input end for obtaining voltages signals of two ends of a silicon-controlled switch, and an output end for sending a zero-crossing triggering signal to the silicon-controlled switch, wherein a bridge type circuit for performing full-wave rectification on the voltages signals of two ends of the silicon-controlled switch, a first optocoupler for feeding the voltage signals back to a central processing unit, a second optocoupler for performing level conversion on the voltages signals of two ends of the silicon-controlled switch to generate a corresponding preliminary zero-crossing pulse signal, a comparison amplifier for generating a silicon-controlled zero crossing point triggering signal, a gating element for performing AND on the zero crossing point triggering signal and a capacitor switch triggering signal sent by a process tuning CPU, and a driver for generating a silicon-controlled zero-crossing trigger driving signal are sequentially arranged between the input end and the output end.

CN 201 418 038 Y aims to disclose an intrinsic safety power supply for mining use, which solves the problems of overlarge inner energy consumption, poor efficiency and overlarge size in the prior external intrinsic safety power supply. The external intrinsic safety power supply comprises a first inductor and an EMI filter made up of a first capacitor, a second capacitor, a third capacitor and a fourth capacitor, wherein, the input end of the EMI filter is connected with the AC input end of the external intrinsic safety power supply, and the output end of the EMI filter is connected with a rectifier bridge.

CN 106 941 387 A aims to disclose an emergency broadcast terminal fault self-check circuit comprising an audio power amplifier device, a sampling control module and a communication module, wherein the sampling control module is coupled to the audio power amplifier device and the communication module, and the communication module is coupled to a terminal device via a mobile data network.

### SUMMARY

In view of the above, the embodiments of the present disclosure provide a vital digital input dynamic sampling circuit, so as to solve the technical problem that signals at the wrong side are misjudged due to failure of the electronic devices existing in the prior art.

The present invention relates to a safe digital input dynamic sampling circuit according to claim 1.

Further, the second pin of the first photoelectric coupler is connected to a first resistor, and the fourth pin of the second photoelectric coupler is connected to the power supply voltage via a second resistor.

Further, the rectifying circuit comprises a first diode and a third resistor; a positive polarity of the digital input signal is connected to an anode of the first diode, a cathode of the first diode is connected to one terminal of the third resistor, and the other terminal of the third resistor is connected to the voltage stabilizing circuit.

Further, the voltage stabilizing circuit comprises a second diode, a third diode and a fourth resistor; the output of the rectifying circuit is respectively connected to a cathode of the second diode and one terminal of the fourth resistor, the other terminal of the fourth resistor is connected to the fourth pin of the first photoelectric coupler, a cathode of the third diode is connected to the second pin of the second photoelectric coupler, an anode of the third diode and an anode of the second diode are respectively connected to a negative polarity of the digital input signal.

Further, when the sampling control signal is 1, a signal acquired by the sampling terminal is consistent with an inverse of a signal inputted at the first input terminal.

Advantageous effects of the embodiments of the present disclosure include: the signal acquired by the sampling terminal is controlled by the sampling control signal at the second input terminal, when the sampling control signal that allows sampling is received, the input signal at the first input terminal is transferred to the sampling terminal, thereby the signal corresponding to the first input terminal is acquired, the input signal of the railway system is determined by comparing whether the signal at the sampling terminal is consistent with the signal at the second input terminal.

### BRIEF DESCRIPTION OF THE DRAWINGS

The above and other objectives, features and advantages of the present disclosure will be more clear through description of the embodiments provided with reference to the following drawings, in the drawings:
FIG. 1 is a block diagram of principle of a vital digital input dynamic sampling circuit provided by an embodiment of the present disclosure; and
FIG. 2 is a schematic diagram of principle of a vital digital input dynamic sampling circuit according to an embodiment of the present disclosure.

### DETAILED DESCRIPTION OF THE EMBODIMENTS

The present disclosure is described below based on embodiments, but the present disclosure is not limited merely to these embodiments. In the following detailed description of the present disclosure, specific details are described thoroughly. The present disclosure can also be fully understood by those skilled in the art without the description of these details. In order to avoid obscuring essence of the present disclosure, commonly-known methods, procedures, processes, elements and circuits are not described in detail.

In the vital digital input dynamic sampling circuit provided by the embodiments of the present disclosure, the signal acquired by the sampling terminal is controlled by the sampling control signal at the second input terminal, when the sampling control signal that allows sampling is received, the input signal at the first input terminal is transferred to the sampling terminal, thereby the signal corresponding to the first input terminal is acquired, the input signal of the railway system is determined by comparing whether the signal at the sampling terminal is consistent with the signal at the second input terminal.

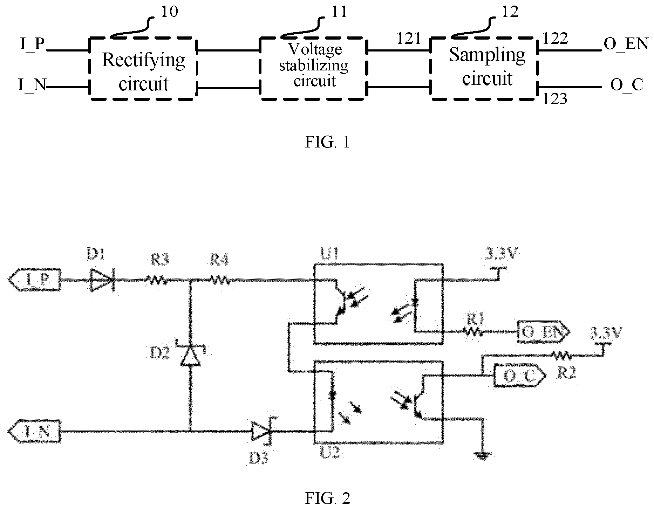

The block diagram of principle of the vital digital input dynamic sampling circuit shown in FIG. 1 includes a rectifying circuit 10, a voltage stabilizing circuit 11 and a sampling circuit 12. The sampling circuit 12 has a first input terminal 121, a second input terminal 122 and a sampling terminal 123. The rectifying circuit 10 is connected to an input signal from the railway system. The rectifying circuit 10 converts the input signal into a DC signal and thereafter inputs it to the voltage stabilizing circuit 11. The voltage stabilizing circuit 11 controls a voltage amplitude between the first input terminal 121 and a negative polarity of the input signal and outputs an outputted DC signal to the first input terminal 121. The second input terminal 122 receives a sampling control signal, controls transfer of the input signal to the sampling terminal 123 through the sampling control signal, and transfers the input signal at the first input terminal 121 to the sampling terminal 123 in response to the sampling control signal that allows sampling.

In the railway system, fixedly, the input signal being 1 represents a wrong side and the input signal being 0 represents a right side. The wrong side refers to the side where hazardous consequences could occur. When a railway equipment or system fails, there are two directions to fall to: the wrong side and the right side. For a safety system, it must be designed to fall to the right side. Therefore, in order to ensure security of the system, it is necessary to reduce the probability that signals at the wrong side are misjudged, that is, to reduce the probability of misjudging as 0 when the input signal is 1.

The input signal is represented by I_P, the sampling control signal is represented by O_EN, the acquired signal is represented by O_C, and a signal truth table is shown below.

| I P signal | O_EN | OC |
|---|---|---|
| 0 | 0 | 1 |
| 0 | 1 | 1 |
| 1 | 0 | 0 |
| 1 | 1 | 1 |

When I_IP is 1, O_EN will be transferred to the sampling terminal 123, so that O_C acquires a signal. When I_P input is 1, turn-on of the sampling circuit 12 is decided by O_EN, thus a state of O C is decided by O_EN; when I_P input is 0, no matter what signal is inputted at O_EN, the sampling circuit 12 cannot be turned on, a state of O C is maintained as 1.

As can be seen from the above table, in a case where the input signal is 1, change of the O_C signal is the same as that of the O_EN signal, thus the O_EN signal transmits a pulse signal of channel codes, and at the same time the O_C signal is detected, and the transmitted codes of O_EN and the codes received by the O_C are compared. When transmitted codes of O_EN are the same as the codes at O_C, it means the input signal I_P is at a high voltage level 1, when O_C receives no channel codes, i.e., the input signal is 0 or devices, systems have a failure, this failure is a failure falling to the right side.

FIG. 2 is a schematic diagram of principle of a vital digital input dynamic sampling circuit according to an embodiment of the present disclosure, said circuit comprises a first diode D1, a second diode D2, a third diode D3, a first resistor R1, a second resistor R2, a third resistor R3, a fourth resistor R4, a first photoelectric coupler U1 and a second photoelectric coupler U2. I_P and I_N are a positive polarity and a negative polarity of the input signal, O_EN is the input terminal of the sampling control signal, and O_C is the sampling terminal.

The rectifying circuit 10 comprises the first diode D1 and the third resistor R3; a positive polarity of the input signal is connected to an anode of the first diode D1, a cathode of the first diode D1 is connected to one terminal of the third resistor R3, and the other terminal of the third resistor R3 is connected to the voltage stabilizing circuit.

The voltage stabilizing circuit 11 comprises the second diode D2, the third diode D3 and the fourth resistor R4; an output of the rectifying circuit (the other terminal of R3) is respectively connected to a cathode of the second diode D2 and one terminal of the fourth resistor R4, the other terminal of the fourth resistor R4 is connected to the fourth pin of the first photoelectric coupler U1, and a cathode of the third diode D3 is connected to the second pin of the second photoelectric coupler U2, an anode of the third diode and an anode of the second diode are respectively connected to a negative polarity of the input signal.

The sampling circuit 12 comprises the first photoelectric coupler U1 and the second photoelectric coupler U2. A fourth pin of the first photoelectric coupler U1 and a second pin of the second photoelectric coupler U2 are connected, as the first input terminal, to the voltage stabilizing circuit, and a third pin of the first photoelectric coupler U1 is connected to a first pin of the second photoelectric coupler U2; a second pin of the first photoelectric coupler U1 serves as the second input terminal, a first pin of the first photoelectric coupler U1 is connected to an output voltage; a fourth pin of the second photoelectric coupler U2 serves as the sampling terminal and also connected to a power supply voltage, and a third pin of the second photoelectric coupler U2 is grounded. The second pin of the first photoelectric coupler U1 is connected to the first resistor R1, and the fourth pin of the second photoelectric coupler U2 is connected to the power supply voltage via the second resistor R2.

When the I_P input is 1, whether U2 is turned on or not is decided by O_EN, thus a signal state of O_C is decided by O_EN; when the I_P input is 0, no matter what signal is inputted at O_EN, the state of O_C is maintained at 1. When O_EN is 0, I_P will be transferred to U2, so that O_C acquires a signal. In a case where the I_P input signal is 1, change of the O_C signal is the same as that of the O_EN signal, thus the O_EN signal transmits a pulse signal of channel codes, and at the same time the O_C signal is detected, and the transmitted codes of O_EN and the codes received by the O_C are compared. When transmitted codes of O_EN are the same as the codes at O_C, it means the input signal I_P is at a high voltage level 1, when O_C receives no channel codes, i.e., the input signal is 0 or devices, systems have a failure.

The first diode D1 in the rectifying circuit 10 is a rectifying diode, its preferred model is MRA4007, the third resistor R3 is preferred to be chip resistor 1206, its resistance value is 2.7K ohms. The second diode D2 in the stabilizing circuit 11 is a TVS (Transient Voltage Suppressor) diode, its preferred model is SMAJ10A, the third diode D3 in the stabilizing circuit 11is a Zener diode, is preferred model is MMSZ5V6, the fourth resistor R4 in the stabilizing circuit 11 is preferred to be chip resistor 1206, its resistance value is 1K ohms. The first photoelectric coupler U1 and the second photoelectric coupler U2 in the sampling circuit 12 are a transistor output photoelectric coupler, its preferred model is TLP281; the first R1 is preferred to be a thick-film chip resistor 0603, its resistance value is 390 ohms, the second resistor R2 is preferred to be a thick-film chip resistor 0603, its resistance value is 3.9K ohms.

The foregoing descriptions are merely preferred embodiments of the present disclosure and are not intended to limit the present disclosure. For those skilled in the art, the present disclosure may have various changes and modifications.

## Claims

1. A safe digital input dynamic sampling circuit, comprising:
a rectifying circuit connected to a digital input signal comprising a positive polarity (I_P) and a negative polarity (I_N), and configured to convert the digital input signal to a direct current, DC, signal;
a voltage stabilizing circuit connected to the rectifying circuit, and configured to control a voltage amplitude of the DC signal to output a stabilized DC signal; and
a sampling circuit including a first input terminal (121), a second input terminal (122) and a sampling terminal (123; O_C), the first input terminal (121) being configured to receive the stabilized DC signal, the second input terminal (122) being configured to receive a sampling control signal (O_EN);
**characterized in that** when the positive polarity (I P) of the digital input signal is high, the state of the sampling terminal (123; O_C) is determined by the sampling control signal (O_EN), and when the when the positive polarity (I_P) is low, the state of the sampling terminal (123; O_C) is maintained high;
wherein the sampling circuit comprises a first photoelectric coupler and a second photoelectric coupler;
wherein a fourth pin of the first photoelectric coupler and a second pin of the second photoelectric coupler are connected, as the first input terminal (121), to the voltage stabilizing circuit, and a third pin of the first photoelectric coupler is connected to a first pin of the second photoelectric coupler; and
wherein a second pin of the first photoelectric coupler serves as the second input terminal (122), a first pin of the first photoelectric coupler is connected to power supply voltage; a fourth pin of the second photoelectric coupler serves as the sampling terminal (123; O_C) and also connected to power supply voltage, and a third pin of the second photoelectric coupler is grounded.

2. The safe digital input dynamic sampling circuit according to claim 1, wherein the second pin of the first photoelectric coupler is connected to a first resistor, and the fourth pin of the second photoelectric coupler is connected to the power supply voltage via a second resistor.

3. The safe digital input dynamic sampling circuit according to claim 1 or 2, wherein the rectifying circuit comprises a first diode and a third resistor; a positive polarity of the digital input signal is connected to an anode of the first diode, a cathode of the first diode is connected to one terminal of the third resistor, and the other terminal of the third resistor is connected to the voltage stabilizing circuit.

4. The safe digital input dynamic sampling circuit according to any one of claims 1 to 3, wherein the voltage stabilizing circuit comprises a second diode, a third diode and a fourth resistor; the output of the rectifying circuit is respectively connected to a cathode of the second diode and one terminal of the fourth resistor, the other terminal of the fourth resistor is connected to the fourth pin of the first photoelectric coupler, and a cathode of the third diode is connected to the second pin of the second photoelectric coupler, an anode of the third diode and an anode of the second diode are respectively connected to a negative polarity of the digital input signal.

5. The safe digital input dynamic sampling circuit according to any one of claims 1 to 4, wherein when the sampling control signal (O_EN) is 0, a signal acquired by the sampling terminal (123; O_C) is consistent with an inverse of a signal inputted at the first input terminal (121).

## Patentansprüche

1. Dynamische Abtastungsschaltung mit sicherem digitalen Eingang, umfassend:
eine Gleichrichtungsschaltung, die an ein digitales Eingangssignal angeschlossen ist, das eine positive Polarität (I_P) und eine negative Polarität (I_N) umfasst, und dazu ausgelegt ist, das digitale Eingangssignal in ein Gleichstromsignal, DC-Signal, umzuwandeln;
eine Spannungsstabilisierungsschaltung, die an die Gleichrichtungsschaltung angeschlossen und dazu ausgelegt ist, eine Spannungsamplitude des DC-Signals zu steuern, um ein stabilisiertes DC-Signal auszugeben; und
eine Abtastungsschaltung, die einen ersten Eingangsanschluss (121), einen zweiten Eingangsanschluss (122) und einen Abtastungsanschluss (123; O_C) enthält, wobei der erste Eingangsanschluss (121) dazu ausgelegt ist, das stabilisierte DC-Signal zu empfangen, wobei der zweite Eingangsanschluss (122) dazu ausgelegt ist, ein Abtastungssteuersignal (O_EN) zu empfangen;
**dadurch gekennzeichnet, dass**, wenn die positive Polarität (I_P) des digitalen Eingangssignal hoch ist, der Zustand des Abtastungsanschlusses (123; O_C) durch das Abtastungssteuersignal (O_EN) bestimmt wird, und wenn die positive Polarität (IP) niedrig ist, der Zustand des Abtastungsanschlusses (123; O_C) auf hoch gehalten wird;
wobei die Abtastungsschaltung einen ersten photoelektrischen Koppler und einen zweiten photoelektrischen Koppler umfasst;
wobei ein vierter Stift des ersten photoelektrischen Kopplers und ein zweiter Stift des zweiten photoelektrischen Kopplers als der erste Eingangsanschluss (121) an die Spannungsstabilisierungsschaltung angeschlossen sind, und ein dritter Stift des ersten photoelektrischen Kopplers an einen ersten Stift des zweiten photoelektrischen Kopplers angeschlossen ist; und
wobei ein zweiter Stift des ersten photoelektrischen Kopplers als der zweite Eingangsanschluss (122) dient, ein erster Stift des ersten photoelektrischen Kopplers an eine Energieversorgungsspannung angeschlossen ist; ein vierter Stift des zweiten photoelektrischen Kopplers als der Abtastungsanschluss (123; O_C) dient und auch an die Energieversorgungsspannung angeschlossen ist, und ein dritter Stift des zweiten photoelektrischen Kopplers an Masse gelegt ist.

2. Dynamische Abtastungsschaltung mit sicherem digitalen Eingang nach Anspruch 1, wobei der zweite Stift des ersten photoelektrischen Kopplers an ein erstes Widerstandselement angeschlossen ist, und der vierte Stift des zweiten photoelektrischen Kopplers über ein zweites Widerstandselement an die Energieversorgungsspannung angeschlossen ist.

3. Dynamische Abtastungsschaltung mit sicherem digitalen Eingang nach Anspruch 1 oder 2, wobei die Gleichrichtungsschaltung eine erste Diode und ein drittes Widerstandselement umfasst; eine positive Polarität des digitalen Eingangssignals an eine Anode der ersten Diode angeschlossen ist, eine Kathode der ersten Diode an einen Anschluss des dritten Widerstandselements angeschlossen ist, und der andere Anschluss des dritten Widerstandselements an die Spannungsstabilisierungsschaltung angeschlossen ist.

4. Dynamische Abtastungsschaltung mit sicherem digitalen Eingang nach einem der Ansprüche 1 bis 3, wobei die Spannungsstabilisierungsschaltung eine zweite Diode, eine dritte Diode und ein viertes Widerstandselement umfasst; der Ausgang der Gleichrichtungsschaltung an eine Kathode der zweiten Diode bzw. einen Anschluss des vierten Widerstandselements angeschlossen ist, der andere Anschluss des vierten Widerstandselements an den vierten Stift des ersten photoelektrischen Kopplers angeschlossen ist, und eine Kathode der dritten Diode an den zweiten Stift des zweiten photoelektrischen Kopplers angeschlossen ist, eine Anode der dritten Diode und eine Anode der zweiten Diode jeweils an eine negative Polarität des digitalen Eingangssignals angeschlossen sind.

5. Dynamische Abtastungsschaltung mit sicherem digitalen Eingang nach einem der Ansprüche 1 bis 4, wobei, wenn das Abtastungssteuersignal (O_EN) 0 ist, ein Signal, das durch den Abtastungsanschluss (123; O_C) erfasst wird, mit einem Kehrwert eines Signals übereinstimmt, das am ersten Eingangsanschluss (121) eingegeben wird.

## Revendications

1. Circuit d'échantillonnage dynamique d'entrée numérique sécurisé,
comprenant :
un circuit redresseur connecté à un signal d'entrée numérique comprenant une polarité positive (I_P) et une polarité négative (I_N), et configuré pour convertir le signal d'entrée numérique en un signal de courant continu, CC ;
un circuit de stabilisation de tension connecté au circuit redresseur, et configuré pour commander une amplitude de tension du signal CC pour sortir un signal CC stabilisé ; et
un circuit d'échantillonnage incluant une première borne d'entrée (121), une deuxième borne d'entrée (122) et une borne d'échantillonnage (123 ; O_C), la première borne d'entrée (121) étant configurée pour recevoir le signal CC stabilisé, la deuxième borne d'entrée (122) étant configurée pour recevoir un signal de commande d'échantillonnage (O_EN) ;
**caractérisé en ce que**, lorsque la polarité positive (I_P) du signal d'entrée numérique est haute, l'état de la borne d'échantillonnage (123 ; O_C) est déterminée par le signal de commande d'échantillonnage (O_EN), et lorsque la polarité positive (I_P) est basse, l'état de la borne d'échantillonnage (123 ; O_C) est maintenue haute ;
sachant que le circuit d'échantillonnage comprend un premier coupleur photoélectrique et un deuxième coupleur photoélectrique ;
sachant qu'une quatrième broche du premier coupleur photoélectrique et une deuxième broche du deuxième coupleur photoélectrique sont connectées, en tant que la première borne d'entrée (121), au circuit de stabilisation de tension, et une troisième broche du premier coupleur photoélectrique est connectée à une première broche du deuxième coupleur photoélectrique ; et
sachant qu'une deuxième broche du premier coupleur photoélectrique sert en tant que la deuxième borne d'entrée (122), une première broche du premier coupleur photoélectrique est connectée à une tension d'alimentation électrique ; une quatrième broche du deuxième coupleur photoélectrique sert en tant que la borne d'échantillonnage (123 ; O_C) et est également connectée à la tension d'alimentation électrique, et une troisième broche du deuxième coupleur photoélectrique est mise à la terre.

2. Le circuit d'échantillonnage dynamique d'entrée numérique sécurisé selon la revendication 1, sachant que la deuxième broche du premier coupleur photoélectrique est connectée à une première résistance, et la quatrième broche du deuxième coupleur photoélectrique est connectée à la tension d'alimentation électrique via une deuxième résistance.

3. Le circuit d'échantillonnage dynamique d'entrée numérique sécurisé selon la revendication 1 ou 2, sachant que le circuit redresseur comprend une première diode et une troisième résistance ; une polarité positive du signal d'entrée numérique est connectée à une anode de la première diode, une cathode de la première diode est connectée à une borne de la troisième résistance, et l'autre borne de la troisième résistance est connectée au circuit de stabilisation de tension.

4. Le circuit d'échantillonnage dynamique d'entrée numérique sécurisé selon l'une quelconque des revendications 1 à 3, sachant que le circuit de stabilisation de tension comprend une deuxième diode, une troisième diode et une quatrième résistance ; la sortie du circuit redresseur est respectivement connectée à une cathode de la deuxième diode et à une borne de la quatrième résistance, l'autre borne de la quatrième résistance est connectée à la quatrième broche du premier coupleur photoélectrique, et une cathode de la troisième diode est connectée à la deuxième broche du deuxième coupleur photoélectrique, une anode de la troisième diode et une anode de la deuxième diode sont respectivement connectées à une polarité négative du signal d'entrée numérique.

5. Le circuit d'échantillonnage dynamique d'entrée numérique sécurisé selon l'une quelconque des revendications 1 à 4, sachant que lorsque le signal de commande d'échantillonnage (O_EN) est 0, un signal acquis par la borne d'échantillonnage (123 ; O_C) coïncide avec un inverse d'un signal entré au niveau de la première borne d'entrée (121).
